# FASCICULE DE BREVET EUROPEEN

(11) **EP 2 488 830 B1**
(45) Date de publication et mention de la délivrance du brevet: **14.01.2015**
(21) Numéro de dépôt: 10785112.3
(22) Date de dépôt: 13.10.2010
(51) Int. Cl.: G01D 5/14, G01D 5/12, B60K 20/00

(54) **CAPTEUR MAGNETIQUE POUR DETERMINER LA POSITION ET L'ORIENTATION D'UNE CIBLE**
MAGNETISCHER SENSOR ZUM BESTIMMEN VON POSITION UND ORIENTIERUNG EINES OBJEKTES
MAGNETIC SENSOR FOR DETERMINING THE POSITION AND ORIENTATION OF A TARGET

(30) Priorité: 14.10.2009 FR 0957189
(43) Date de publication de la demande: 22.08.2012
(73) Titulaire: Electricfil Automotive, 01708 Miribel Cedex (FR)
(72) Inventeur: LIEBARD, Vincent, F-01120 La Boisse (FR)
(74) Mandataire: Thibault, Jean-Marc
(86) Numéro de dépôt international: PCT/FR2010/052175
(87) Numéro de publication internationale: WO 2011/045540

(56) Documents cités:
- FR-A1- 2 786 266
- FR-A1- 2 829 574
- FR-A1- 2 860 867

## Description

La présente invention concerne le domaine technique des capteurs magnétiques sans contact adaptés pour déterminer la position d'une pièce mobile évoluant selon une trajectoire déterminée combinant un mouvement linéaire et un mouvement de rotation.

L'objet de l'invention trouve une application particulièrement avantageuse mais non exclusivement dans le domaine des véhicules automobiles en vue d'équiper différents organes à déplacement limités linéaires et rotatifs dont la position doit être connue.

L'objet de l'invention trouve une application particulièrement avantageuse dans le domaine technique des capteurs de position pour la boîte de vitesses d'un véhicule automobile.

Dans l'état de la technique, il est connu par exemple par la demande de brevet FR 2 904 394, un capteur de position pour une boîte de vitesses d'un véhicule automobile comportant une cible aimantée destinée à être fixée sur la tige d'actionnement des rapports d'une boîte de vitesses. Cette tige d'actionnement est mobile en rotation et en translation et se déplace en fonction des mouvements du levier de vitesses. Ce capteur comprend également un composant à effet Hall apte à mesurer le champ magnétique selon trois directions orthogonales permettant de déterminer la position et l'orientation de la cible dans l'espace en vue d'en déduire la position de la boîte de vitesses.

Un inconvénient de ce capteur magnétique concerne son manque de précision compte tenu de la difficulté de disposer d'une mesure fiable tout au long de la rotation de la cible quelque soit la translation et tout le long de la translation quelque soit la rotation. Par ailleurs, la mesure effectuée est très sensible à la variation d'entrefer c'est-à-dire à la variation de distance entre la cible et le composant de mesure à effet Hall.

Le brevet FR 2 786 266 décrit un capteur permettant de déterminer la position d'une pièce mobile en translation et en rotation. Selon une caractéristique de réalisation, un tel capteur comporte une demi-bague aimantée radialement mobile entre deux stators ferromagnétiques intérieurs et deux stators ferromagnétiques extérieurs. Les deux stators intérieurs présentent une forme en demi-lune et délimitent entre eux un premier entrefer tandis que les deux stators extérieurs en forme de bague délimitent un deuxième entrefer. Une sonde à effet Hall est montée dans chacun de ces entrefers. Lorsque la bague aimantée se déplace en rotation et en translation, elle engendre une variation d'induction magnétique dans chacun des deux entrefers secondaires. Un tel capteur permet de déterminer la position d'une pièce en fonction de la mesure de l'amplitude de l'induction magnétique réalisée par les deux sondes à effet Hall. Un tel capteur nécessite la mise en oeuvre de plusieurs pièces ferromagnétiques entraînant des contraintes d'encombrement. De plus, un tel capteur présente une précision relative au bon positionnement des sondes.

Dans le même sens, le brevet FR 2 829 574 décrit un capteur permettant de déterminer la position d'un objet mobile en translation et en rotation. Un tel capteur comporte un aimant cylindrique engagé à l'intérieur d'une carcasse cylindrique coaxiale définissant deux circuits magnétiques délimitant chacun un entrefer dans lequel est placé un capteur sensible à l'amplitude de l'induction magnétique. Un tel capteur permet de déterminer la position axiale et angulaire entre la carcasse magnétique et l'aimant en fonction de l'amplitude de l'induction magnétique mesurée par les capteurs placés dans les entrefers. La mise en oeuvre d'une carcasse ferromagnétique entraîne des contraintes d'encombrement pour la réalisation d'un tel capteur de position. Par ailleurs, le capteur de position présente un inconvénient lié à son imprécision relative au bon positionnement des sondes.

La présente invention vise donc à remédier aux inconvénients de l'état de la technique en proposant un nouveau capteur magnétique apte à déterminer la position d'une pièce mobile linéairement et en rotation, avec une grande précision tout le long de la trajectoire ce, même pour une variation relativement importante de l'entrefer de mesure.

Pour atteindre un tel objectif le capteur magnétique selon l'invention pour déterminer la position d'une pièce mobile d'une part, en rotation selon une course angulaire limitée selon un mouvement de rotation et d'autre part, en translation selon un axe de translation et selon une course linéaire limitée, ce capteur comportant d'une part une cible aimantée montée solidaire de la pièce mobile et se présentant sous la forme d'une portion de cylindre aimantée radialement possédant un axe de symétrie confondu avec l'axe de translation et d'autre part un système de mesure de l'induction magnétique de la cible aimantée pour déterminer la position de la cible dans l'espace.

Selon l'invention, le système mesure en un même point, la direction de l'induction magnétique dans deux plans orthogonaux dont l'un est normal au mouvement de rotation et dont l'autre est normal au mouvement de translation afin de déterminer la position et l'orientation de la cible.

L'objet de l'invention concerne également un capteur magnétique comportant en combinaison l'une et et/ou l'autre des caractéristiques suivantes :
- le système de mesure traite un signal de mesure proportionnel à la direction de l'induction magnétique dans le plan normal au mouvement de rotation et un signal de mesure proportionnel à la direction de l'induction magnétique dans le plan normal au mouvement de translation,
- le système de mesure comporte des moyens de mesure sensibles à la direction de l'induction magnétique,
- le système de mesure comporte des cellules à effet Hall sensibles aux composantes de l'induction magnétique selon trois axes normaux entre eux,
- le système de mesure comporte un étage de traitement des signaux de mesure proportionnels à l'orientation de l'induction magnétique dans les plans normaux au mouvement de rotation et au mouvement de translation, de manière à délivrer des signaux correspondant à la position et à l'orientation de la cible,
- le système de mesure comporte un étage de quantification des signaux correspondant à la position et à l'orientation de la cible afin de délivrer un signal tout ou rien,
- la portion de cylindre est aimantée radialement d'une extrémité à l'autre,
- la portion de cylindre est aimantée radialement dans sa partie centrale et selon une direction évolutive tendant à une direction orthoradiale aux extrémités de ladite portion,
- la cible aimantée est montée solidaire en tant que pièce mobile, d'une tige d'actionnement des rapports de vitesse.

Un autre objet de l'invention est une boîte de vitesses comportant une tige d'actionnement des rapports de vitesse, mobile en rotation et en translation sur des courses limitées comprenant un capteur magnétique conforme à l'invention.

Diverses autres caractéristiques ressortent de la description faite ci-dessous en référence aux dessins annexés qui montrent, à titre d'exemples non limitatifs, des formes de réalisation de l'objet de l'invention.
La **Figure 1** est une vue schématique en perspective montrant un exemple de réalisation du capteur magnétique conforme à l'invention.
La **Figure 2** est une vue de dessus du capteur magnétique conforme à l'invention.
La **Figure 3** est une vue en élévation du capteur magnétique conforme à l'invention.
La **Figure 4** est une vue schématique d'un autre exemple d'aimantation de la cible aimantée conforme à l'invention.
La **Figure 5** est un schéma bloc fonctionnel du système de mesure du capteur magnétique selon l'invention.
Les **Figures 6A** à **6C** sont des vues montrant le capteur de position dans trois positions de rotation en l'absence de translation.
Les **Figures 7A** et **7B** sont des courbes illustrant les signaux de mesure de la direction α de l'induction magnétique et de translation St en fonction de la translation x de la cible aimantée.
Les **Figures 8A** à **8C** illustrent le capteur de position dans trois positions de translation, en l'absence de rotation.
Les **Figures 9A** et **9B** sont des courbes illustrant les signaux de mesure de la direction ϕ de l'induction magnétique et de rotation Sr en fonction de la rotation ω de la cible aimantée.

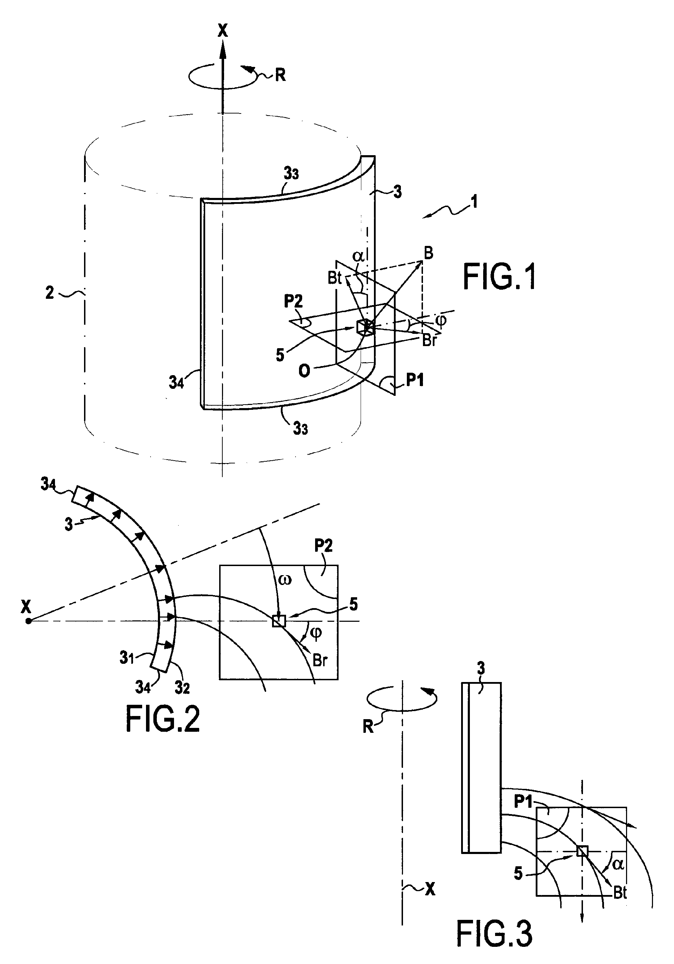

Tel que cela ressort plus précisément des **Fig. 1** à **3****,** l'objet de l'invention concerne un capteur magnétique **1** adapté pour déterminer la position d'une pièce **2** au sens général mobile d'une part en translation selon un axe de translation **X** et en rotation autour de l'axe de translation **X.** Le capteur **1** comporte une cible aimantée **3** montée solidaire par tout moyen approprié avec la pièce mobile **2.** Le capteur magnétique **1** comporte également un système **5** de mesure de la direction de l'induction magnétique **B** de la cible aimantée **3** afin de déterminer la position et l'orientation de la cible aimantée **3** dans l'espace. Le système de mesure **5** est monté de manière fixe relativement à la cible aimantée **3** mobile.

Le capteur magnétique **1** est donc adapté pour déterminer la position de la cible aimantée **3** et par suite de la pièce **2,** la cible aimantée **3** et la pièce **2** étant mobile d'une part en rotation selon une course angulaire ω limitée s'établissant selon un mouvement **R** tournant autour de l'axe de translation **X** et d'autre part en translation selon l'axe de translation **X** et selon une course linéaire limitée **x.**

Conformément à l'invention, la cible aimantée **3** est une portion de cylindre présentant un axe de symétrie confondu avec l'axe de translation **X.** La cible aimantée **3** est donc définie par une face interne **3₁** et une face externe **3₂** parallèles entre elles et présentant chacune une courbure centrée sur l'axe de translation **X.** Les faces **3₁, 3₂** sont délimitées par des bords périphériques **3₃, 3₄.** La cible aimantée **3** présente une épaisseur par exemple de l'ordre de quelques mm et s'étend sur une plage angulaire dépendant de la variation de l'angle de rotation à mesurer. Par exemple, cette plage angulaire peut s'étendre entre 40 et 110°. Dans l'exemple illustré, la cible aimantée **3** possède d'une part des bords opposés **3₃** s'étendant selon des plans parallèles entre eux et perpendiculaires à l'axe de translation **X,** et d'autre part, des bords périphériques opposés **3₄** s'étendant en longueur selon des directions parallèles entre elles et à l'axe de translation **X.** Selon cet exemple, la projection de la cible aimantée **3** s'inscrit dans un rectangle. Bien entendu, la cible aimantée **3** peut présenter une forme différente, en fonction de la trajectoire de la pièce **2** à détecter.

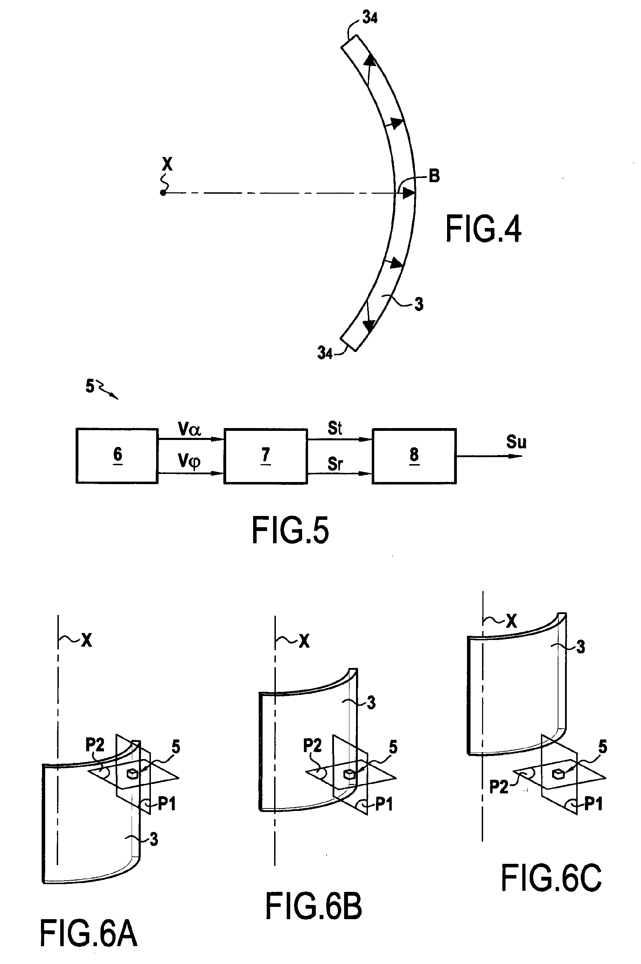

Selon une caractéristique de l'invention, la cible aimantée **3** est aimantée radialement c'est-à-dire que l'axe magnétique est orienté selon une direction radiale perpendiculaire à l'axe de déplacement **X** et passant par l'axe de déplacement **X (****Fig. 2****).** Selon une première variante de réalisation illustrée à la **Fig. 2****,** la cible aimantée **3** est aimantée radialement d'un bord périphérique **3₄** à l'autre. En d'autres termes, l'axe magnétique de la cible aimantée **3** passe par l'axe de déplacement **X** sur toute la mesure angulaire de la portion de cylindre. Selon une autre variante de réalisation illustrée à la **Fig. 4****,** la cible aimantée **3** est aimantée radialement dans sa partie centrale telle que décrit ci-dessus et selon une direction évolutive tendant à une direction orthoradiale aux bords périphériques **3₄.** L'axe magnétique de la cible aimantée **3** présente donc une direction évolutive ou graduelle à partir d'une direction radiale dans la partie centrale de la cible aimantée 3 et se rapprochant d'une aimantation orthoradiale vers les bords périphériques **3₄.**

Selon une autre caractéristique de l'invention, le système **5** mesure en un même point, la direction de l'induction magnétique **B** dans deux plans orthogonaux dont l'un **P₁** est normal au mouvement de rotation **R** et dont l'autre **P₂** est normal au mouvement de translation **X** afin de déterminer la position et l'orientation de la cible mobile **2.** En d'autres termes, le plan **P₁** dit de translation est donc parallèle à l'axe de déplacement **X** en étant perpendiculaire au mouvement de rotation **R** tandis que le plan **P₂** dit de rotation est perpendiculaire à l'axe de déplacement **X.**

Le système de mesure **5** permet donc de mesurer dans le plan de translation **P₁,** la direction α de l'induction magnétique et dans le plan de rotation **P₂,** la direction ϕ de l'induction magnétique. En effet, l'induction magnétique **B** délivrée par la cible mobile **3** comporte une composante **Bt** appartenant au plan de translation **P₁** et une composante **Br** appartenant au plan de rotation **P₂.** Tel que cela ressort de la **Fig. 1****,** les composantes **Br** et **Bt** s'étendent respectivement dans les plans de rotation **P₂** et de translation **P₁** en ayant un point commun d'origine **O.**

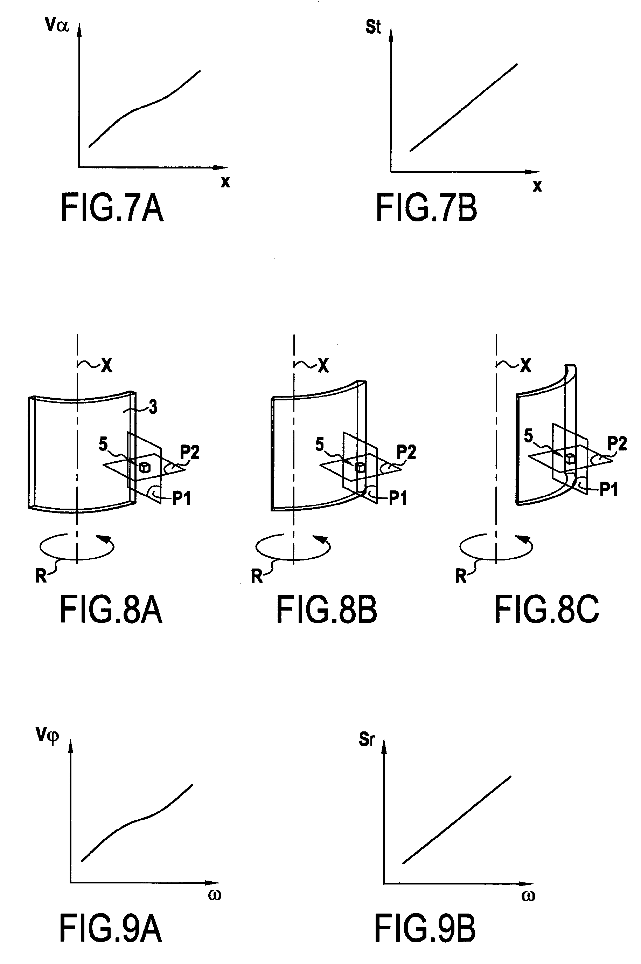

Ainsi, tel que cela ressort plus précisément à la **Fig. 3****,** le système de mesure **5** permet de mesurer la direction α de la composante **Bt** de l'induction magnétique qui évolue en fonction de la position en translation de la cible mobile **3** par rapport au système de mesure **5 (****Fig. 3****).** La mesure au point origine **O** de la direction de la composante **Bt** de l'induction appartenant au plan **P₁** normal à la rotation **R** permet de détecter la position de la cible aimantée **3.** Les **Fig. 6A** à **6C** illustrent la trajectoire de la cible aimantée 3 au cours de la translation **x,** selon l'axe de déplacement **X,** en l'absence de rotation. La variation de l'angle α étant monotone, le signal de mesure **V**α est également monotone **(****Fig. 7A****).**

De même, le système de mesure **5** permet de mesurer la direction de la composante **Br** de l'induction magnétique qui évolue en fonction de la position en rotation de la cible mobile **3** par rapport au système de mesure **5 (****Fig. 2****).** La mesure au point origine **O** de la direction de la composante **Br** de l'induction appartenant au plan **P₂** normal à la translation **X** permet de détecter l'orientation de la cible aimantée **3.** Les **Fig. 8A** à **8C** illustrent la trajectoire de la cible aimantée **3** au cours de sa rotation ω selon le mouvement de rotation **R,** en l'absence de translation. La variation de l'angle ϕ étant monotone, le signal de mesure **V**ϕ est également monotone **(****Fig 9A****).**

Tel que cela ressort de la **Fig. 5****,** le système de mesure **5** comporte des moyens de mesure **6** qui peuvent être directement sensibles à la direction de l'induction magnétique ou bien permettant la reconstitution des signaux **V**α, **V**ϕ proportionnels aux angles α, ϕ caractérisant la direction de l'induction magnétique dans les plans respectivement **P₁** et **P₂.** Par exemple, une mesure des composantes de l'induction selon les trois axes **x, y, z** du repère lié au système de mesure **5,** par une technologie Hall, permet une détermination de ces angles α, ϕ.

Il est à noter que le système de mesure **5** mesure la direction de l'induction magnétique **B** considérée en un unique point de l'espace, sans la mise en oeuvre d'éléments statoriques visant à guider le flux magnétique dans le système de mesure. En d'autres termes, le système de mesure **5,** mesure directement la direction naturelle du champ magnétique créé par la cible aimantée **3.** La mesure de la direction du champ magnétique en un unique point de mesure, sans la mise en oeuvre de pièces polaires, favorise l'intégration d'un tel capteur dans un encombrement limité.

Les signaux **V**a, **V**ϕ délivrés par les moyens de mesure **6** sont traités par un étage de gain électrique **7** pour disposer de deux signaux linéaires **St, Sr (****Fig. 7B****, 9B)** qui sont le reflet respectivement de la translation x et de la rotation ω de la cible mobile **3.** Il est à noter que le mouvement de translation **X** influe très peu sur le signal **Sr** reflet du mouvement de rotation **R.** Réciproquement, le mouvement de rotation **R** influe très peu sur le signal **St** reflet du mouvement de translation. Le capteur magnétique selon l'invention constitue un capteur robuste combinant les mouvements de rotation **R** et de translation **X.** Un tel capteur s'avère en pratique peu sensible aux variations de distance entre le système de mesure **5** et la cible aimantée **3** puisque le système **5** mesure la direction de l'induction magnétique qui varie peu en fonction des variations de distance entre le système de mesure **5** et la cible aimantée **3.**

Selon une variante de réalisation, le système de mesure **5** comporte un étage **8** de quantification des signaux **St, Sr** délivrés par l'étage **7.** Cette variante de réalisation permet de délivrer un signal unique **Su** qui est une combinaison des signaux **St, Sr** et correspondant à un signal tout ou rien.

Le capteur magnétique **1** trouve une application particulièrement avantageuse mais non exclusivement pour la boîte de vitesses d'un véhicule automobile. A cet effet, la cible aimantée **3** est fixée ou aménagée sur la tige d'actionnement des rapports d'une boîte de vitesses. Le capteur magnétique **1** selon l'invention permet ainsi de connaître la position du levier de vitesses dont le passage et la sélection des vitesses se traduisent par une rotation et une translation de la tige commandée par le levier.

L'invention n'est pas limitée aux exemples décrits et représentés car diverses modifications peuvent y être apportées sans sortir de son cadre.

## Revendications

1. Capteur magnétique pour déterminer la position d'une pièce **(2)** mobile d'une part, en rotation selon une course angulaire (ω) limitée selon un mouvement de rotation **(R)** et d'autre part, en translation selon un axe de translation **(X)** et selon une course linéaire limitée **(x),** ce capteur comportant d'une part, une cible aimantée **(3)** montée solidaire de la pièce mobile **(2)** et se présentant sous la forme d'une portion de cylindre aimantée radialement possédant un axe de symétrie confondu avec l'axe de translation **(X)** et d'autre part, un système **(5)** de mesure de l'induction magnétique de la cible aimantée pour déterminer la position de la cible dans l'espace, **caractérisé en ce que** le système **(5)** mesure en un même point, la direction de l'induction magnétique dans deux plans orthogonaux dont l'un **(P₁)** est normal au mouvement de rotation **(R)** et dont l'autre **(P₂)** est normal au mouvement de translation **(X)** afin de déterminer la position et l'orientation de la cible.

2. Capteur magnétique selon la revendication 1, **caractérisé en ce que** le système de mesure **(5)** traite un signal de mesure **(V**α**)** proportionnel à la direction de l'induction magnétique dans le plan **(P₁)** normal au mouvement de rotation **(R)** et un signal de mesure **(V**ϕ**)** proportionnel à la direction de l'induction magnétique dans le plan **(P₂)** normal au mouvement de translation **(X).**

3. Capteur magnétique selon la revendication 2, **caractérisé en ce que** le système de mesure **(5)** comporte des moyens de mesure **(6)** sensibles à la direction de l'induction magnétique.

4. Capteur magnétique selon la revendication 2, **caractérisé en ce que** le système de mesure **(5)** comporte des cellules à effet Hall sensibles aux composantes de l'induction magnétique selon trois axes normaux entre eux.

5. Capteur magnétique selon l'une des revendications 1 à 4, **caractérisé en ce que** le système de mesure **(5)** comporte un étage de traitement **(7)** des signaux de mesure **(V**α**, V**ϕ**)** proportionnels à l'orientation de l'induction magnétique dans les plans normaux au mouvement de rotation **(R)** et au mouvement de translation **(X),** de manière à délivrer des signaux **(St, Sr)** correspondant à la position et à l'orientation de la cible.

6. Capteur magnétique selon la revendication 5, **caractérisé en ce que** le système de mesure **(5)** comporte un étage **(8)** de quantification des signaux correspondant à la position et à l'orientation de la cible afin de délivrer un signal tout ou rien.

7. Capteur magnétique selon la revendication 1, **caractérisé en ce que** la portion de cylindre est aimantée radialement d'une extrémité **(3₄)** à l'autre **(3₄).**

8. Capteur magnétique selon la revendication 1, **caractérisé en ce que** la portion de cylindre est aimantée radialement dans sa partie centrale et selon une direction évolutive tendant à une direction orthoradiale aux extrémités de ladite portion.

9. Capteur magnétique selon la revendication 1, **caractérisé en ce que** la cible aimantée **(3)** est montée solidaire en tant que pièce mobile, d'une tige d'actionnement des rapports de vitesse.

10. Boîte de vitesses comportant une tige d'actionnement des rapports de vitesse, mobile en rotation et en translation sur des courses limitées, **caractérisé en ce qu'**elle comprend un capteur magnétique **(1)** conforme à l'une des revendications 1 à 9.

## Patentansprüche

1. Magnetsensor für die Bestimmung der Position eines Teils (2), das einerseits entlang eines begrenzten Winkelweges (ω) in einer Rotationsbewegung (R) drehbeweglich und andererseits entlang einer Verschiebeachse (X) und entlang eines begrenzten Linearweges (x) verschiebebeweglich ist, wobei dieser Sensor einerseits ein magnetisiertes Ziel (3), das mit dem beweglichen Teil (2) fest verbunden angebracht ist und in Form eines radial magnetisierten Zylinderabschnitts, welcher eine mit der Verschiebeachse (X) zusammenfallende Symmetrieachse besitzt, vorliegt, sowie andererseits ein System (5) zur Messung der magnetischen Induktion des magnetisierten Ziels umfasst, um die Position des Ziels im Raum zu bestimmen, **dadurch gekennzeichnet, dass** das System (5) an einer gleichen Stelle die Richtung der magnetischen Induktion in zwei orthogonalen Ebenen misst, von denen die eine (P₁) zu der Rotationsbewegung (R) normal verläuft und die andere (P₂) zu der Verschiebebewegung (X) normal verläuft, um die Position und die Ausrichtung des Ziels zu bestimmen.

2. Magnetsensor nach Anspruch 1, **dadurch gekennzeichnet, dass** das Messsystem (5) ein Messsignal (Vα), das zu der Richtung der magnetischen Induktion in der zu der Rotationsbewegung (R) normalen Ebene (P₁) proportional ist, sowie ein Messsignal (Vϕ), das zu der Richtung der magnetischen Induktion in der zu der Verschiebebewegung (X) normalen Ebene (P₂) proportional ist, verarbeitet.

3. Magnetsensor nach Anspruch 2, **dadurch gekennzeichnet, dass** das Messsystem (5) Messmittel (6), die gegenüber der Richtung der magnetischen Induktion empfindlich sind, umfasst.

4. Magnetsensor nach Anspruch 2, **dadurch gekennzeichnet, dass** das Messsystem (5) Hall-Zellen, die gegenüber den Komponenten der magnetischen Induktion entlang von drei untereinander normalen Achsen empfindlich sind, umfasst.

5. Magnetsensor nach einem der Ansprüche 1 bis 4, **dadurch gekennzeichnet, dass** das Messsystem (5) eine Stufe zur Verarbeitung (7) der Messsignale (Vα, Vϕ), die zu der Ausrichtung der magnetischen Induktion in den zu der Rotationsbewegung (R) und zu der Verschiebebewegung (X) normalen Ebenen proportional sind, umfasst, um Signale (St, Sr), die der Position und der Ausrichtung des Ziels entsprechen, bereitzustellen.

6. Magnetsensor nach Anspruch 5, **dadurch gekennzeichnet, dass** das Messsystem (5) eine Stufe (8) zur Quantisierung der der Position und der Ausrichtung des Ziels entsprechenden Signale umfasst, um ein Ein-Aus-Signal bereitzustellen.

7. Magnetsensor nach Anspruch 1, **dadurch gekennzeichnet, dass** der Zylinderabschnitt von einem Ende (3₄) zum anderen (3₄) radial magnetisiert ist.

8. Magnetsensor nach Anspruch 1, **dadurch gekennzeichnet, dass** der Zylinderabschnitt in seinem mittleren Teil und in einer fortschreitenden Richtung, die eine orthoradiale Richtung an den Enden des Abschnitts anstrebt, radial magnetisiert ist.

9. Magnetsensor nach Anspruch 1, **dadurch gekennzeichnet, dass** das magnetisierte Ziel (3) als bewegliches Teil mit einer Stange zur Betätigung der Übersetzungsverhältnisse fest verbunden angebracht ist.

10. Getriebe, umfassend eine Stange zur Betätigung der Übersetzungsverhältnisse, die auf begrenzten Wegen dreh- und verschiebebeweglich ist, **dadurch gekennzeichnet, dass** es einen Magnetsensor (1) gemäß einem der Ansprüche 1 bis 9 umfasst.

## Claims

1. A magnetic sensor for determining the position of a part (2) movable firstly in rotation over a limited angular stroke (ω) by virtue of a rotary movement (R), and secondly in translation along a translation axis (X) and over a limited linear stroke (x), this sensor including both a magnetized target (3) mounted on and fastened to the movable part (2) and taking the form of a radially-magnetized part-cylinder having an axis of symmetry coinciding with the translation axis (X) and also a system (5) for measuring the magnetic field of the magnetized target to determine the position of the target in three dimensions, the sensor being **characterized in that**, in order to determine the position and the orientation of the target, the system (5) acts at a single point to measure the direction of the magnetic field in two orthogonal planes, one of which (P₁) is normal to the rotary movement (R) and the other of which (P₂) is normal to the movement in translation (X).

2. A magnetic sensor according to claim 1, **characterized in that** the measuring system (5) processes a measuring signal (Vα) proportional to the direction of the magnetic field in the plane (P₁) normal to the rotary movement (R) and a measuring signal (Vϕ) proportional to the direction of the magnetic field in the plane (P₂) normal to the movement in translation (X).

3. A magnetic sensor according to claim 2, **characterized in that** the measuring system (5) includes measuring means (6) sensitive to the direction of the magnetic field.

4. A magnetic sensor according to claim 2, **characterized in that** the measuring system (5) includes Half-effect cells sensitive to the components of the magnetic field along three mutually-orthogonal axes.

5. A magnetic sensor according to any one of claims 1 to 4, **characterized in that** the measuring system (5) includes a stage (7) for processing measurement signals (Vα, Vϕ) proportional to the orientation of the magnetic field in the planes normal to the rotary movement (R) and to the movement in translation (X), in such a manner as to deliver signals (St, Sr) corresponding to the position and to the orientation of the target.

6. A magnetic sensor according to claim 5, **characterized in that** the measuring system (5) includes a stage (8) for quantizing the signals corresponding to the position and to the orientation of the target in order to deliver a binary signal.

7. A magnetic sensor according to claim 1, **characterized in that** the part-cylinder is magnetized radially from one end (3₄) to the other (3₄).

8. A magnetic sensor according to claim 1, **characterized in that** the part-cylinder is magnetized radially in its central portion and in an evolving direction tending toward a circumferential direction at the ends of said portion.

9. A magnetic sensor according to claim 1, **characterized in that** the magnetized target (3) is mounted on and fastened to a movable part in the form of a gear change actuator rod.

10. A gearbox including a gear change actuator rod that is movable in rotation and in translation over limited strokes, the gearbox being **characterized in that** it includes a magnetic sensor (1) according to any one of claims 1 to 9.
